# EUROPEAN PATENT APPLICATION

(11) **EP 3 364 205 A1**
(43) Date of publication of application: **22.08.2018**
(21) Application number: 17020058.8
(22) Date of filing: 17.02.2017
(51) Int. Cl.: G01R 33/385, G01R 33/28, G01R 33/561

(54) **METHOD AND APPARATUS FOR ULTRASONIC GRADIENTS IN MAGNETIC RESONANCE IMAGING**

(71) Applicant: MR Coils, BV, 5301 KR Zaltbommel (NL); vd Velden, Tijl, 5301 KR Zaltbommel (NL); Rivera, Debra Strick, 5301 KR Zaltbommel (NL); Hendrikse, Arjan, 5301 KR Zaltbommel (NL); Siero, Jeroen, 5301 KR Zaltbommel (NL); Klomp, Dennis, 5301 KR Zaltbommel (NL)
(72) Inventor: vd Velden, Tijl, 5301 KR Zaltbommel (NL); Rivera, Debra, 5301 KR Zaltbommel (NL); Hendrikse, Arjan, 5301 KR Zaltbommel (NL); Siero, Jeroen, 5301 KR Zaltbommel (NL); Klomp, Dennis, 5301 KR Zaltbommel (NL)

(57) **Abstract**

The herein described invention relates to a gradient system and method that allows for a spatial encoding gradient driven at high (> 10 kHz) or ultrasonic (= or >20 kHz) frequencies in order to achieve fast slew-rate high-strength spatial encoding gradients without generating vibration in the auditory range and without inducing peripheral nerve stimulation. Rise time is proportional to inductance, therefore gradient coils that minimize inductance per generated magnetic-flux density allow for faster switching rates. Such a system can be implemented for example, as an insert gradient coil (in 1,2, or 3 axis) to augment the in-bore gradient system, in close proximity to the head or imaging target, and may exclude counter-windings, and thus create a minimum inductance for a given magnetic flux density. The use of spatial encoding gradients at increased drive frequency reduces the moment of inertia and thus magneto-mechanical vibrations, and therefore allows for more light-weight construction of coils and elimination of counter-winding for self-shielding coils. An embodiment of the presented invention is the use of high-frequency gradients in combination with 3 phase encoding directions and receive coil spatial sensitivity profiles to enable parallel imaging with acceleration in 3 dimensions.

## Description

The present invention relates to magnetic resonance imaging, more specifically the spatial encoding gradients of the magnetic resonance system.

Magnetic resonance imaging (MRI) is performed on an MRI scanner. A MRI scanner typically consists of a large static magnetic field B0, a set of radio frequency coils or antennas for generating an alternating magnetic field B1 and collecting the MR signal, and a set of gradient coils to allow spatial encoding on the B0 field which is required for tomographic imaging.

Spatial encoding of the MR signals is achieved by fast switching of three orthogonal magnetic field gradients (X, Y, Z) located in the scanner bore that surrounds the body often combined with encoding caused by coil sensitivity profiles. Spatial Current state of the art, involves driving spatial-encoding gradients in the kHz range (0-10 kHz) as specified in US 5610521 A. Given that the gradients are driven in the auditory range (<<20 kHz), considerable efforts have gone towards methods for reducing the noise caused by the Lorenz forces induced in and by the switching gradients. One such method, disclosed in DE 102004042100 A1, incorporates vibration dampening material in order to reduce the noise. Additional methods incorporate counter-wound turns concentric to and in series with the gradient coil windings tightly coupled to the same rigid mass, creating a self-shielding structure in which the magneto-motive forces are anti-phase and therefore cancel for either primary gradients as in DE 102004042100 A1 or for an insert gradient, such as US 5235279 A.

To boost the MRI spatiotemporal resolution, the gradient system needs to be driven faster and stronger, in other words with higher gradient slew-rates (T per m per s) and higher gradient strengths (mT per m). The other means of spatial encoding by coil sensitivity profiles is limited by enhanced g-factors (noise amplification due to spatially correlating sensitivity profiles). At present, the gradient performance is chiefly limited by uncomfortable peripheral nerve stimulations (PNS) induced by too fast switching of a strong magnetic field gradient. Switching of the gradients induces electrical fields and currents in conducting tissue such as muscles and nerves and may result in nerve depolarization and ultimately nerve stimulation. A viable strategy for faster and stronger gradient coil performances while preventing nerve stimulation is I) to reduce the extent of the gradient field and thus the associated electric field and II) to reduce the switch times below the PNS threshold (IEC guidelines).

For improved spatiotemporal resolution of MRI it is necessary to increase spatial encoding gradient strength and switching speed which are currently limited primarily by the need to minimize peripheral nerve stimulation. Spatial gradient systems generated vibration in the auditory range, requiring rigid housing for dampening the vibration and minimizing the risk of hearing damage. The herein described invention relates to a gradient system and method that allows for a spatial encoding gradient that can be driven at ultrasonic frequencies (= or > 20 kHz) as in claim 1, or high frequencies (>10 kHz) as in claim 2 to provide high resolution MRI, and thereby overcome the aforementioned limitations of conventional gradient systems. Inductance is proportional to the ramp time, therefore gradient coils that minimize inductance per generated magnetic field have shorter rise times and thus allow for faster switching rates. The present invention provides the following advantages over the state of the art: vibrations occurring from fast-switching gradients are outside of the range of human hearing as in claim 1, voltage requirements of the gradient signal generators are diminished due to less copper windings as in claim 3, the moment of inertia caused by the short duration of the Lorentz forces on the gradient system are reduced thereby allowing for a less robust and lighter weight housing as in claim 6, peripheral nervous stimulation is no longer a limiting factor (occurs at > 100 us) as in claim 7, and such a system, capable of fast-switching strong gradients results in a greatly increased MRI temporal resolution, particularly when combined with high density receiver coil arrays (as in claim 8) and existing state-of-the art scanning techniques (as in claim 9) and high power gradient amplifiers.

In the drawings:

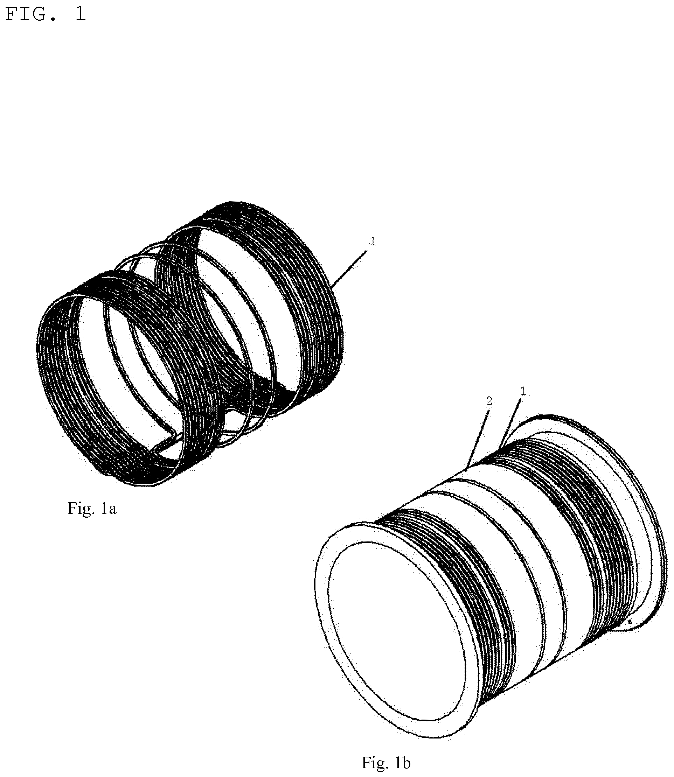

Fig. 1 provides views of the copper windings 1 of an embodiment of the presented invention providing 1-axis of spatial encoding above 10 kHz, in which coil inductance is minimized by the lack or a return or self-shielding counter-wound section. The copper windings 1 are shown alone in Fig. 1a, and in Fig. 1b the copper windings 2 are mounted on a former (aka structure) 2 on which the gradient windings are supported is lightweight in accordance with claim 6.

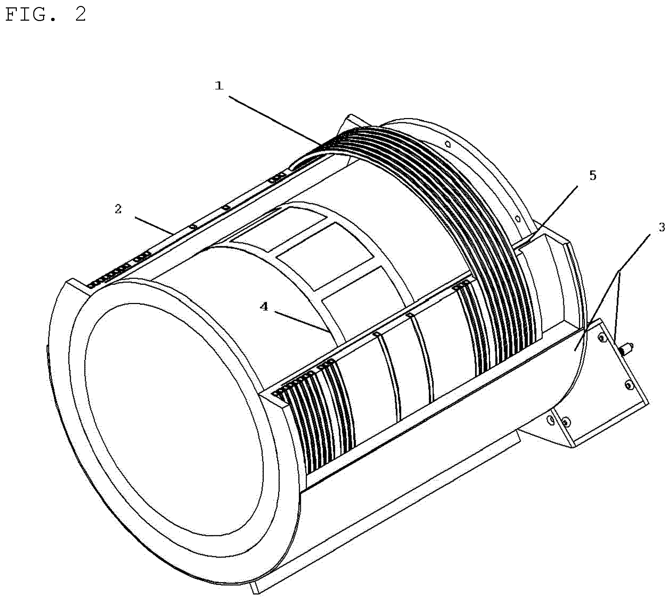

Fig. 2 presents an embodiment of the invention as described in claim 4 in which a single axis of spatial encoding is implemented as an insert high-frequency gradient, with the high-frequency gradient winding 1 mounted on a lightweight structure 2 contained within a housing 3 for mounting on an MRI scanner bed. The housing 3 also contains an RF coil 4 and an RF shield embedded in the gradient coil structure 2.

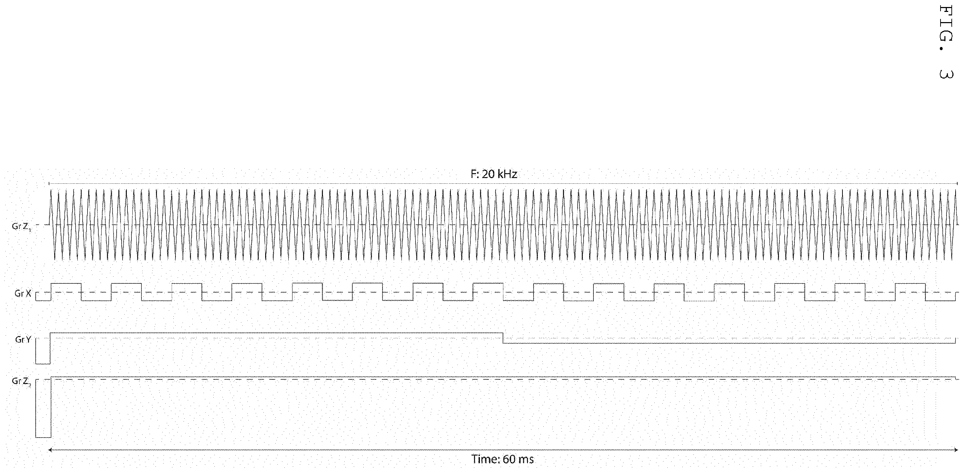

Fig. 3 depicts a simplified representation of the gradient waveforms of an accelerated 3D single shot EPI trajectory. Gr Z¬1 is performed at an ultrasonic frequency. Gr X and Gr Y are performed at frequencies in the acoustic range, but with a low amplitude. Gr Z2 ensures an additional phase encoding in the readout direction.

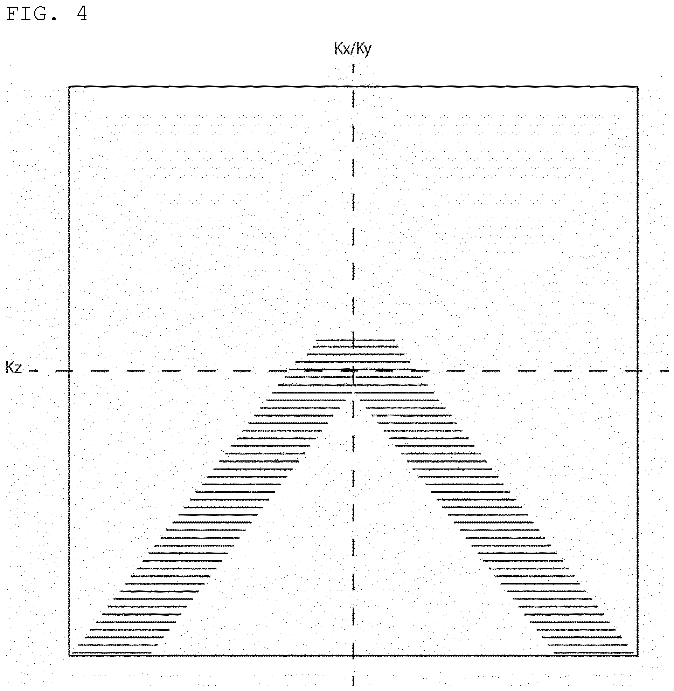

Fig. 4 depicts a 2D simplification of the k-space trajectory of the sequence shown in Fig.3. Each line represents the acquisition during a single lobe of the magnetic gradient field switching at a frequency of 20 kHz.

Herein after, further details of the present invention will be in the context of specific embodiments, though are not limited by the scope of the presented embodiments.

An embodiment of the invention is as an insert gradient coil (in 1,2, or 3 axis) to augment the in-bore gradient system, in close proximity to the head or imaging target as in claim 4, and may exclude counter-windings, and thus create a minimum inductance for a given magnetic flux density. A further embodiment of the invention described in claim 1, wherein the windings of the high frequency (> 10 kHz) gradient coil are made of hollow tubings to allow fluid-based cooling as in claim 5.

In order to also maximize spatial resolution in the presence of the fast-switching gradients, an additional direction of spatial encoding can be added with high density RF coil receiver arrays. Phase encoding is done on a larger time-scale than read-out (aka frequency) encoding, and therefore more amenable to acceleration. So far, receiver arrays have been used to accelerate in either 1 or 2--and in the rare-case 3--phase encoding directions, but for MRI never in the read-out direction. Moving from 1 dimension to 2 dimensions already boosted acceleration at preserved g-factor. When increasing to 3 dimensions, acceleration can be increased even further without sacrificing g-factor. The reason for accelerating in 3 directions is that the number of useful samples that can be obtained during one lobe of the ultra-fast EPI readout is limited, and may be less than required for high spatial resolution. Here we propose to use phase encoding in 3 dimensions in addition to the readout in one dimension to further enhance spatial resolution.

For clarity we provide, an example embodiment of the presented invention of an ultrasonic (20 kHz) z-direction gradient head insert such as that shown in Fig. 2 used in combination with the x-, y-, and z-gradients of the MRI scanner for brain imaging.

For a 3D MRI with a spatial resolution of 2mm x 2mm x 1mm (x, y, z) with a field of view of 15 cm x 15 cm x 20 cm using a z-gradient of 160 mT/m and slew rate of 13000 T/m/s, a suitable bandwidth is 15 cm x 166 mT/m x 42.5 MHz/T = 1 MHz. A 20 kHz z-gradient provides 25 micro sec lobes, thus 25 data points per lobe (1 MHz x 25 micro s). Current state of the art gradient amplifiers can provide 2 kV and 1 kA, hence can drive a copper-wound head gradient coil 1 as seen in Fig. 1 with this performance. For a typical T2* contrast a 60 ms acquisition window can be used; this provides 240 z-lobes with a 20 kHz z-gradient. Adding a constant z-gradient during the readout period facilitates additional phase encoding in this z-dimension. Accelerating 4 fold in z-direction using an array of coils that provide different sensitivity profiles along z then requires only 2 phase encode steps in the z direction to end up in 2 x 4 x 25 = 200 data points in z-direction. Adding a blipped or constant phase encoding in the y-direction could facilitate 15 lines and using coil sensitivity profile differences in the y-direction may extend 5-fold into a y-direction resolution of 2 mm. Finally, using a slow low power EPI train in X-direction can generate 15 or even 8 lines if half k-space scanning is used that can translate in a spatial resolution of 2 mm in x-direction as well. A simplified representation of a pulse sequence of this example is shown in Fig. 3 and the corresponding acquired k-space (excluding coil sensitivity acceleration) in Fig. 4.

Additional embodiments of the present invention incorporate high-frequency or ultrasonic switching gradients in more than one direction, such that read-out trajectories through k-space are not limited to those presented herein.

## Claims

1. : A method of operating a magnetic resonance imaging (MRI) system having a gradient coil, **characterized by** driving the MRI field gradients above the human auditory range ( = or > 20 kHz).

2. : The use of frequencies above 10 kHz for driving MRI spatial encoding gradients.

3. : A magnetic field gradient coil system comprising of coils that provide at least one axis of spatial encoding in which one or more of the coils are designed with minimal inductance such that the coil(s) can be driven at high frequency (> 10 kHz) and due to the minimal inductance require limited voltage.

4. : A gradient system as in claim 3 in which one or more axis of spatial encoding is implemented all or in part as a gradient insert coil.

5. : A magnetic field gradient coil system comprising of coils that provide at least one axis of spatial encoding in which one or more of the coils are driven at high frequency (> 10 kHz) and are made of hollow conductors to facilitate efficient cooling.

6. : A magnetic field gradient coil system comprising of coils that provide at least one axis of spatial encoding **characterized in that** the intended use of the coils is for high frequency switching gradients (= or > 10 kHz) and therefore can be made lightweight due to the reduced moment of inertia associated with shortened duration of Lorenz forces as the drive frequency is increased.

7. : A method of operating spatial encoding gradients for MRI **characterized by** the use of high frequency switching gradients in order to prevent peripheral nerve stimulation.

8. : The use of an array of RF receivers to extend the spatial encoding of high frequency (>10 kHz) switching of gradient fields MRI readout of EPI or any trajectory through k-space of any dimensions.

9. : A method as in claim 8 in which g-factors get minimized and parallel imaging encoding schemes (e.g. CAIPIRINHA) become more effective from 3D acceleration.
